# EUROPEAN PATENT SPECIFICATION

(11) **EP 3 782 863 B1**
(45) Date of publication and mention of the grant of the patent: **11.12.2024**
(21) Application number: 19465545.2
(22) Date of filing: 21.08.2019
(51) Int. Cl.: B60S 1/08, G01N 27/04, H05K 3/40, H05K 1/11

(54) **HUMIDITY SENSING MODULE, HYDROLYSIS PREVENTION MODULE AND HUMIDITY SENSOR COMPRISING HUMIDITY SENSING MODULE**
FEUCHTIGKEITSMESSMODUL, HYDROLYSEVERHINDERUNGSMODUL UND FEUCHTIGKEITSSENSOR MIT DEM FEUCHTIGKEITSMESSMODUL
MODULE DE DÉTECTION D'HUMIDITÉ, MODULE DE PRÉVENTION D'HYDROLYSE ET DÉTECTEUR D'HUMIDITÉ COMPRENANT LE MODULE DE DÉTECTION D'HUMIDITÉ

(43) Date of publication of application: 24.02.2021
(73) Proprietor: Continental Autonomous Mobility Germany GmbH, 85057 Ingolstadt (DE)
(72) Inventor: Maris, Darius-Dorin, 300704 Timisoara (RO)
(74) Representative: Continental Corporation

(56) References cited:
- EP-A1- 2 336 758
- US-A- 4 665 351

## Description

### Field of the invention

The invention is related to protection against humidity effects of a printed circuit boards PCB on which electrical or electronical components are mechanically supported and electrically connected. In particular, the invention refers to a humidity sensing module for humidity sensors, a humidity sensor, and a hydrolysis prevention module comprising said humidity sensing module that may be used for measuring the ambient humidity on the printed circuit board PCB area for the purpose of detecting if said humidity is above a predetermined threshold.

### Terms used in this invention

In this invention, the term "layer" refers to an electrically conductive layer of the printed circuit board PCB.

Any printed circuit board PCB has two outer layers, namely the layers that are placed at the exterior of said printed circuit board PCB. For the invention, it is not relevant to individualize each of the two outer layers, because humidity can occur on any of the outer layers, and in particular on any of the outer surfaces of the two outer layers of the printed circuit board PCB.

The term "ground plane" refers exclusively to the layer of copper foil connected to the printed circuit board's ground point, serving as return path for current from many components.

One of the outer layers may be the ground plane.

The term "via", also known as vertical interconnect access, is an electrical connection between layers of the printed circuit board PCB.

### Background of the invention

There is a wide variety of situations of humidity in a printed circuit board PCB, stemming from the fact that today, printed circuit boards PCBs are used in a wide range of fields of sub-assembly of some embedded system, such as but not limited to: in the automotive industry for various electronic control units of the vehicles; in computers and hand-held devices of all sizes; in camera sensors; in sensors in general, etc.

Humidity can be of various sources, but generally falls within two categories: in gaseous form, namely vapour, and in liquid form, usually water vapour condensation or water from direct sources.

Each printed circuit board PCB may be exposed to different types and levels of humidity, because of factors such as: the location of the printed circuit board PCB in the general architecture of the sub-assembly comprising it, the electrical or electronical components accommodated by the printed circuit board, the ambient temperature and humidity and the speed of their variation with time, the characteristics of the printed circuit board such as the size, the number of layers. For example, in some cases, humidity may affect primarily areas located in one outer surface of the outer layer in one specific zone of the printed circuit board PCB, while in other cases humidity may affect the entire outer surface of the outer layers of the printed circuit board in a diffuse manner.

As a general rule, when humidity from various sources reaches any outer surface of the outer layer or both outer layers of a printed circuit boards PCB, hydrolysis occurs, creating the condition of electrochemical corrosion. Further on, the electrochemical corrosion may be the source of various effects such as short-circuits, overheating of the printed circuit board PCB, partial or total interruption of the functioning of the electrical or electronical components accommodated by said printed circuit boards PCB and, in extreme cases, may lead to explosion.

As a consequence, printed circuit boards PCB need to be protected against excess of humidity. Said protection consist of identification of excess humidity, followed by appropriate measures to protect the printed circuit boards PCB against humidity.

For the purpose of such detection, humidity sensors are used to detect changes in relative humidity or temperature in many components, including printed circuit boards PCB. Said humidity sensors are placed by the manufacturer in predetermined place or places of the printed circuit board PCB.

US2009/0134985 A1 for example disclosed a modular sensor unit for a motor vehicle for detecting ambient conditions which comprises at least two sensor modules, wherein a first sensor module has a rain and/or condensation sensor, and a second sensor module has at least a light and/or solar sensor. In this case, there preferably is an electrical and/or electronic connection between the sensor modules.

EP2336758A1 discloses a humidity sensing module for sensing humidity on at least one pre-determined humidity-prone zone of at least one of the outer surfaces of the two outer layers of a printed circuit board connected to a voltage source. The mentioned printed circuit board comprises at least two electrically conductive layers (a ground plane, a signal layer) ; a plurality of positive and negative vias is arranged in pairs such that the positive via of each pair has an end connected to the pre-determined humidity-prone zone of the outer surface of the two outer layers and the other end connected to a transistor layer, and the negative via of each pair has an end connected to the pre-determined humidity-prone zone of the same outer surface of the two outer layers and the other end connected to the ground plane.

Moreover, US4665351A discloses a resistive rain sensor that uses a patterned electrode as detector configured to determine single drops of rain.

### Disadvantages of prior art

One of the disadvantages in the prior art is the lack of the possibility to detect the humidity in multiple zones of the printed circuit board PCB and/or in specific zones of said printed circuit board PCB.

Yet another disadvantage as it appears from the prior art is that the humidity sensors for printed circuit board PCB are not efficient in operation and/or detection since they provide only local reading, while they need a lot of space to be mounted on the printed circuit board PCB.

### Problem solved by the invention

The problem solved by the invention is to provide a humidity sensing module able to detect the humidity in multiple zones of any of the outer surfaces of a printed circuit board PCB and to provide a possibility to adjust the sensitivity of the humidity sensing module according to the characteristics of each individual printed circuit board PCB.

### Summary of the invention:

In order to solve the problem, the inventors conceived a humidity sensing module for detecting humidity on at least one pre-determined humidity-prone zone of at least one of the outer surfaces of the two outer layers of a printed circuit board, said printed circuit board being connected to a voltage source, and comprising at least two electrically conductive layers: the first of the at least two electrically conductive layers being the ground plane and the other of at least two electrically conductive layer being a signal layer supporting electrical or electronical components.

The humidity sensing module further comprises a transistor layer as a further signal layer, said transistor layer and said ground plane being connected to said voltage source by two resistors configured to work as a voltage divider, such as:
- said ground plane is connected to voltage source by a first resistor and a second resistor, and
- said transistor layer is connected to said voltage source between first resistor and the second resistor,

The humidity sensing module further comprises a plurality of vias, which are arranged in pairs, such that:
- the positive via of each pair has an end connected to at least one pre-determined humidity-prone zone of one of the outer surfaces of the two outer layers and the other end connected to said transistor layer;
- the negative via of each pair has an end connected to at least one pre-determined humidity-prone zone of the same outer surface of the two outer layers and the other end connected to said ground plane;
and an external decision taking module connected between said two resistors being configured to read the signal and interpret it depending on the different voltage level between said resistors.

The humidity sensing module according to the invention is configured such that when humidity between a positive via and a negative via, placed at a predetermined distance between them on the same outer surface, exceeds a humidity threshold, they become electrically connected determining a signal of different voltage level between said resistors depending on the level of humidity exceeding a predetermined threshold and thus allowing said signal to be read and interpreted by said external decision taking module.

In another aspect of the invention it is provided a hydrolysis prevention module comprising the humidity sensing module, wherein the external decision taking module is configured to disconnect the current flow in at least one pre-determined humidity-prone zone Zj of at least one of the outer surfaces of the two outer layers of a printed circuit board in order to limit the effect of hydrolysis on at least one pre-determined humidity-prone zone of at least one of the outer surfaces of the two outer layers of a printed circuit board when the level of humidity exceeds a predetermined threshold.

In another aspect of the invention, it is provided a humidity sensor comprising said humidity sensing module or said hydrolysis prevention module.

### Advantages of the invention

The main advantages of this invention are the following:
i) Flexibility and adaptability. The invention allows to measure the humidity on more than one zone, in such a way as to reflect the zones of each printed circuit board PCB that are most likely to be affected by humidity.
ii) Wide range of sensitivity. The invention allows to fine tune the process of sensing the humidity by selecting: the number of pairs of vias, the distance between them, the number of pre-determined humidity-prone zones and the values of the resistors. In case this may not be sufficient, an even wider range of sensitivity may be obtained by using additional components, in such a way as to address the needs of sensing the humidity in a wide variety of printed circuit boards PCB arising from practice.
iii) Earlier detection of humidity. By sensing the humidity on more than one zone and by fine tuning the process of measuring the humidity, the invention allows an earlier detection of the humidity in the outer surfaces of the outer layers of the printed circuit boards PCB, thus allowing the measures to protect said printed circuit boards PCB be taken earlier than in the state of art and thus prolonging the life of the printed circuit board PCB and reducing the time and costs for the replacement of the printed circuit board PCB and the related damaged electrical and/or electronical components.
iv) Easy manufacturing and implementation, low costs. The invention requires using ordinary components such as the layers of the printed circuit board, resistors, transistors, switches, vias, etc. that do not require significant space and do not require substantial resources for managing them, leading to lower costs.

Further advantages will stem from the description, claims and drawings.

### Brief description of the drawings

Fig.1 - Humidity sensing module -schematically general layout;
Fig. 2 - Humidity sensing module -schematically cross-view showing the pairs of vias placed in pre-determined zones of the outer surfaces of the two outer layers of a printed circuit board PCB;
Fig. 3 - A preferred embodiment of the humidity sensing module having included a transistor
Fig 4 - A preferred embodiment of the humidity sensing module having included a sensibility regulator comprising a capacitor C1 and a third resistance R3.

### List of references in the drawings:

- PCB: Printed circuit board
- L₁: Ground plane of the printed circuit board
- L_{T}: Transistor layer of the printed circuit board
- L₂...Lₙ: Electrically conductive layer (s) of the printed circuit board
- Vcc: Voltage source
- R1, R2, R3: Electrical resistors
- T: Transistor
- CT1: First electrical contact terminal of the circuit
- CT2: Second electrical contact terminal of the circuit
- C1: Capacitor
- Vi+, Vm+,Vk+: Positive vias
- Vi-, Vm-,Vk-: Negative vias
- µC: External decision taking module
- d: distance between the positive via Vi+ and the negative via Vi-
- Zj: pre-determined humidity-prone zone

### Detailed description

The principle of the invention is based on the inventor's observation that solutions of measuring the humidity in a printed circuit board PCB from the state of the art are configured to measure said humidity in a single zone of it, whereas in practice, the zone or zones most affected by humidity may not necessarily be the ones where the humidity sensors are placed.

The above-mentioned disadvantages of prior art are overcome by providing a humidity sensing module, a humidity sensor, and a hydrolysis prevention module comprising said humidity sensing module capable to detect if an excess of humidity occurs in any zone of the outer surfaces of the outer layers of the printed circuit board PCB.

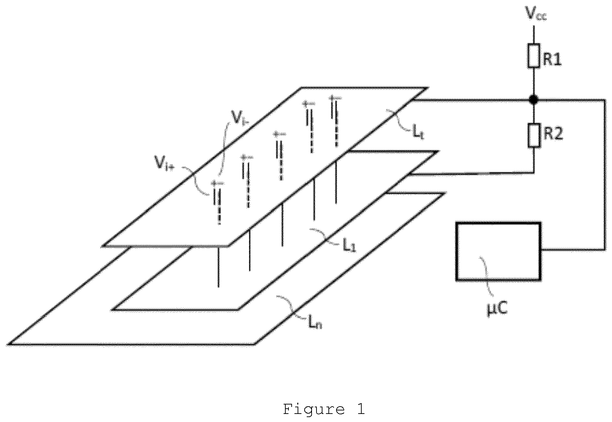

With reference to Fig. 1, in a first aspect of the invention it is disclosed a humidity sensing module for detecting humidity on at least one pre-determined humidity-prone zone Zj of the at least one of the outer surfaces of the two outer layers of a printed circuit board (PCB), the pre-determined humidity-prone zone Zj being the zones where humidity is more likely to occur on any of the two outer surfaces of the two outer layers of the printed circuit board or on both.

For each individual printed circuit board PCB, the localization of the at least one pre-determined humidity-prone zone Zj of any of the outer surfaces of the two outer layers of the printed circuit board PCB may be previously known from the experience or estimated in case there is no experience. The exact localization of at least one pre-determined humidity-prone zone Zj for at least one of the outer surfaces of the two outer layers of the printed circuit board PCB can be made using the dimensions of the printed circuit board PCB, just like in a map.

Further on, in the invention it is defined a humidity threshold that refers, as its name suggests, to a threshold separating the humidity value that is considered not affecting negatively the at least one pre-determined humidity-prone zone Zj from the humidity value considered to be capable of damaging the printed circuit board PCB in the at least one pre-determined humidity-prone zone Zj.

The humidity threshold can be expressed either as relative humidity or as absolute humidity, depending on the particulars of each case. For example, if the ambient temperature of the housing where the printed circuit board PCB is located is likely to vary significantly, such as for example outdoor variations from summer to winter, it is better to define the threshold in terms of relative humidity.

With reference to Fig 1 to 4, the humidity sensing module according to the invention comprises a printed circuit board PCB connected to a voltage source (Vcc) having at least two electrically conductive layers L₁... Lₙ, the first of the at least two layers is the ground plane L₁ and the other at least one layer L₂...Lₙ is signal layer.

The voltage source may be a continuous or variable in time voltage source (Vcc).

The minimum number of layers of the printed circuit board PCB required for the invention is two: the ground plane L₁ and the signal layer L₂. The total number of layers depends on the purpose for which the printed circuit board PCB is configured and it is not relevant for the invention.

The humidity sensing module according to the invention further comprises a new signal layer of the printed circuit board PCB, specific to the invention, in addition to the ground plane L₁ and the other at least one signal layer L₂...Lₙ called the transistor layer L_{T}.

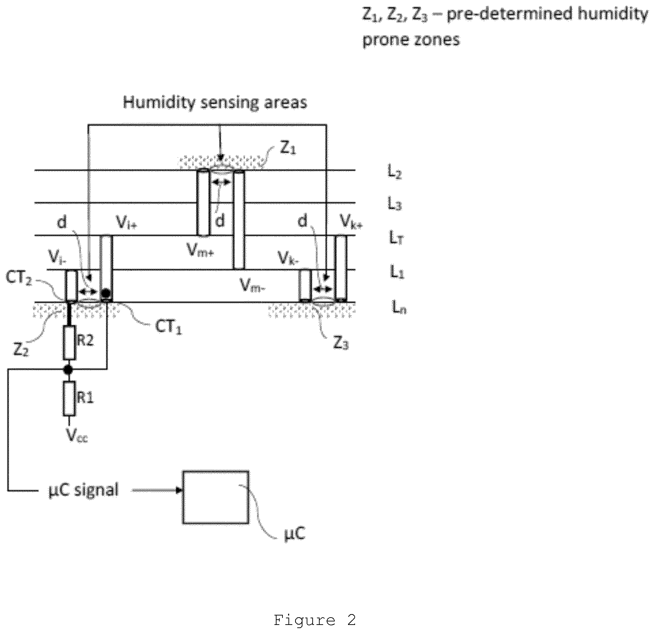

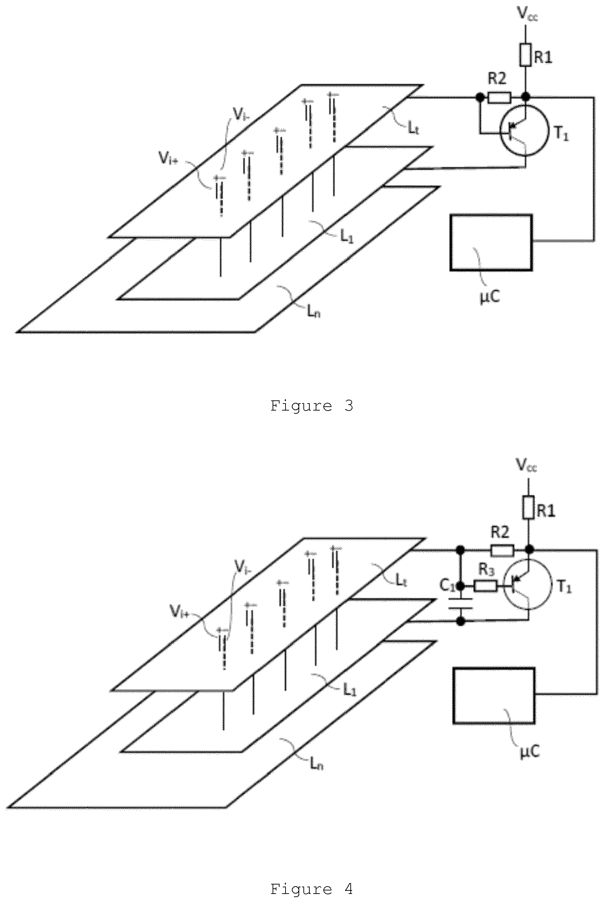

The transistor layer L_{T} may be placed in any position, as intermediate layer between the ground plane L₁ and the other at one signal layer L₂...Lₙ, as illustrated in Fig 2 or as an outer layer on any side of the printed circuit board PCB, as illustrated in Fig.3.

The selection of the position of the transistor layer L_{T} is carried out based on technical considerations, such as efficiency of use of the space. As it is known that the outer layers are usually used for accommodating the electrical or electronical components, it may be more efficient to position the transistor layer L_{T} as intermediate layer. The working of the invention is not affected by the position of the transistor layer L_{T}.

The transistor layer L_{T} and ground plane L₁ are connected to voltage source Vcc by two resistors R1, and R2 configured to work as a voltage divider. The ground plane L1 is connected to voltage source Vcc by a first resistor R1 and a second resistor R2, and transistor layer L_{T} is connected to said voltage source Vcc between first resistor R1 and the second resistor R2.

The electrical resistivity values of the first resistor R1 and, respectively of the second resistor R2 are selected depending on the required sensitivity of the humidity sensing module.

With reference to Fig 1 to 4, the humidity sensing module electric circuit further comprises a plurality of vias Vi+, Vi-arranged in pairs. The pairs of vias are placed in at least one pre-determined humidity-prone zone Zj of any of the outer surfaces of the two outer layers of the printed circuit board PCB at a pre-determined distance d, one from another.

Said plurality of vias Vi+, Vi- are specific to the invention, being added supplementary to any other vias that are accommodated within the printed circuit board PCB for functionality purposes of said printed circuit board PCB.

In order to allow the configurations of the plurality of vias Vi+, Vi- said transistor layer (L_{T}) is configured to accommodate the plurality of positive vias (Vi+), whereas said ground plane (L₁) is configured to accommodate the plurality of negative vias (Vi-).

The specific configurations of the plurality of vias Vi+, Vi- are as follows:
- the positive via of each pair (Vi+) has an end connected to at least one pre-determined humidity-prone zone Zj of the at least one of the two outer surfaces of the PCB and the other end connected to said transistor layer (L_{T}) ;
- the negative via of each pair (Vi-) has an end connected to at least one pre-determined humidity-prone zone Zj of the at least one of the two outer surfaces of the PCB and the other end connected to said ground plane (L₁) .

Thus, one of the two ends of each via Vi+, Vi- reaches the same outer surface, whereas the other end of each via reaches the transistor layer LT, if the via is the positive one Vi+, or the ground layer (L1), if the via is the negative one Vi-.

The principle of the invention is to provide the plurality of vias Vi+, Vi- arranged in pairs, each via of the pair having one respective end configured as sensing elements such that, when the humidity threshold is exceeded on at least one humidity sensing areas from the at least one pre-determined humidity-prone zone Zj, the vias Vi+ and Vi-, placed at a predetermined distance d, become electrically connected determining a different voltage level between said resistors R1, R2.) depending on the level of humidity exceeding predetermined threshold

An external decision taking module µC is connected between said two resistors R1, R2 being configured to read the signal and interpret it depending on the different voltage level between said resistors (R1, R2).

In case pre-determined humidity-prone zones Zj are defined on both outer surfaces, such as the case illustrated in Fig 2, there is an electrical connection between the positive vias Vi+ connecting the transistor layer L_{T}, respectively the negative via Vi- connecting ground plane L₁ with one of the outer surfaces and the positive vias Vi+ connecting the transistor layer L_{T}, respectively the negative via Vi- connecting ground plane L₁ with the other outer surface. The electrical connection between vias is in particular advantageous, creating an efficient humidity sensing module, since it allows detection of the humidity in a short time from the moment of exceeding of the humidity threshold, on any of humidity-prone zones Zj defined on any of the both outer surfaces, and using the same components for all positive vias Vi+, and for all negative vias Vi-.

When the printed circuit board PCB is configured for future use, the pairs of vias Vi+, Vi- are placed in the at least one pre-determined humidity-prone zone Zj, any of them covering said zone uniformly or not uniformly.

When humidity increases in the at least one pre-determined humidity-prone zone Zj over the pre-determined humidity threshold, irrespective of whether humidity is vapour or water, there are two situations:
- either humidity arises between the positive via Vi+ and the negative via Vi- of each pair, case in which the pre-determined distance d between the positive via Vi+ and the negative via Vi- of each pair defines the humidity sensing areas having roughly the dimension of said distance *d;* or
- the humidity arises between any vias of opposed signs placed in the pre-determined humidity-prone zone Zj, not necessarily the ones that form one pair, for example Vi+ and Vk- from Fig 2, case in which the humidity sensing area is defined by the pre-determined distance d between the positive via Vi+ and the negative via Vk- from the pre-determined humidity-prone zone Zj.

In both cases, when humidity is below said pre-determined humidity threshold, the air between the positive via Vi+ and the negative via Vi-, respectively Vk- acts as a dielectric between the positive via Vi+ and the negative via Vi-. When humidity raises, the insulation capability of the air as dielectric drops to a critical point corresponding to the pre-determined humidity threshold, where due to the electrical conductivity phenomenon, the air can no longer insulate the positive via Vi+ from the negative via Vi- respectively Vk- and, consequently said vias Vi+ and Vi-, or respectively Vi+ and Vk- becomes electrically connected and further connected to the humidity sensing module electrical circuit, creating a different voltage level between resistors R1 and R2. Further, on the external decision taking module µC which is connected between said two resistors R1, R2 reads the signal and interprets it in order to take the appropriate decisions.

The plurality of vias is configured in respect to the required level of sensitivity depending on the particulars of each printed circuit board PCB, having the advantage of increased flexibility in sensing various levels of humidity.

The following features of the plurality of vias contribute to the sensitivity of the humidity sensing module:
- the distance *d* between the positive via Vi+ and the negative via Vi- of each pair;
- the number of pairs of vias Vi+, Vi- from each pre-determined humidity-prone zone Zj;
- the size, the position and the number of the pre-determined humidity-prone zone Zj situated on any outer surface or on both outer surfaces where said plurality of vias have the corresponding end;

### The distance d

The distance *d* has usual values as accepted in the industry.

The greater the distance d between the positive via Vi+ and the negative via Vi- of each pair, the greater the width of the dielectric and a higher threshold of humidity is necessary to trigger conductivity, thus the less sensitive the humidity sensing module. On the contrary, the smaller the distance d between the positive via Vi+ and the negative via Vi- of each pair, the smaller the width of the dielectric and a lower threshold of humidity is necessary to trigger conductivity, thus more sensitive the humidity sensing module.

### The number of pairs

Having in view the cumulative effect of the electrical conductivity phenomenon, the more pairs of vias, the more sensitive the humidity sensing module is, because by adding the values of the dielectric strength of the pairs, the same humidity threshold is reached earlier. On the contrary, the less pairs of vias, the less sensitive the humidity sensing module. The minimum number of pairs for each pre-determined humidity-prone zone Zj is one pair.

### The size and the number of the at least one pre-determined humidity-prone zone Zj situated on any outer surfaces or on both outer surfaces

The larger each pre-determined humidity-prone zone Zj is and/or the more pre-determined humidity-prone zones Zi are, the more sensitive the humidity sensing module is because by adding the values of the dielectric of the pairs, the same humidity threshold is reached earlier. It may be possible that one humidity-prone zone Zj be the entire surface of any outer surface or of both outer surfaces of the printed circuit board PCB, for example in case the printed circuit board PCB is placed in a sub-assembly heavily exposed to humidity.

In Fig 2 a non-limiting example is illustrated where:
- there are three pre-determined humidity-prone zones, one humidity-prone zone Z1 on the outer layer L2 and two humidity-prone zones Z2 and Z3 on the outer layer Ln.
- 10 pairs of vias may be placed in zone Z1, out of which one pair of vias is represented graphically: the pair Vm+ and Vm- connecting the transistor layer L_{T} respectively ground plane L₁ with the outer surface of the PCB.
- 8 pairs of vias may be placed in zone Z2, out of which one pair of vias is represented graphically: the pair Vi+ and Vi- connecting the transistor layer L_{T} respectively ground plane L₁ with the outer surface of the PCB.
- 9 pairs may be placed in zone Z3 out of which one pair of vias is represented graphically: the pair Vk+ and Vk-connecting the transistor layer L_{T} respectively ground plane L1 with the outer surface of the PCB.

Once the vias Vi+ and Vi-, placed at a predetermined distance (d) between them, irrespectively of whether they belong to the same pair or not, become electrically connected, due to humidity effects determine a signal of different voltage level between said resistors (R1, R2) depending on the level of humidity exceeding a predetermined threshold and thus allowing said signal to be read and interpreted by said external decision taking module (µC).

In a preferred embodiment of the invention, the specific signal depending on the voltage between the two resistors read by the external decision taking module µC is an analogical signal having a value which varies directly proportional with humidity level between the positive via (Vi+) and negative vias (Vi-) placed at said predetermined distance (d).

In a preferred embodiment, the humidity sensing module according to the invention, as it is shown in the Figure 3, further comprises a transistor T which is connected with its emitter to said voltage source Vcc by first resistor R1, with its collector directly connected to said ground plane L₁ and its base directly connected to transistor layer L_{T}.

The second resistor R2 is connected in this case between emitter and base of said transistor T, keeping the direct connection between base and Transistor layer L_{T}.

The transistor T is thus configured to work as a switch from Open Switch to Close Switch and from Close Switch to Open Switch depending on the signal received in base, signal which is dependent on the humidity.

Once humidity drops below the humidity threshold, the air between the vias Vi+ and Vi- of the same pair or respectively Vi+ and Vk- plays again its role of dielectric and the transistor T is operated from Close Switch to Open Switch and there is no more electric current flowing through the humidity sensing module electric circuit.

External decision taking module µC is configured to receive signal on the operation of the transistor T from Open Switch to Close Switch and from Close Switch to Open Switch, and to commute between two digital values:
- a first digital value corresponding to the operation Close Switch of said transistor T and
- a second digital value corresponding to the operation Open Switch of said transistor T.

The first digital value corresponding to the operation Close Switch of said transistor T further corresponds to the exceeding of the humidity threshold, whereas the second digital value corresponding to the operation Open Switch of said transistor T further corresponds to not exceeding said humidity threshold.

The configuration of external decision taking module µC allows the possibility to read the signal and interpret it depending on the different voltage level between said resistors (R1, R2).

In an embodiment of the invention, the external decision taking module µC, may be a micro-controller or a logical gate. The selection of the type of external decision taking module µC depends on the characteristics and the functions of the printed circuit board PCB and of the sub-assembly where said printed circuit board PCB is used. For example, if a logical gate already exists in said sub-assembly carrying out other functions, it can be further configured to be used for the purpose of including it in the humidity sensing module electric circuit. In other situations, it may be preferable to use a dedicated micro-controller, for example in case there are many pre-determined humidity- prone zones Zj.

The advantage of the invention to be very flexible in sensing of the humidity stems by the possibility to define a wide range of humidity thresholds and zones while configuring the layers of each printed circuit board PCB.

In some situations, additional flexibility and wider sensitivity of the humidity sensing module can be obtained after the configuration of said printed circuit board PCB by adding other electrical components to the humidity sensing module electric circuit.

In another preferred embodiment, a resistor R3 is connected to the base of the transistor to provide stability of the signal, and at least a capacitor C1 between the ground plane L1 and the Transistor layer L_{T to} filter the signal.

The invention discloses in a second aspect a hydrolysis prevention module comprising the humidity sensing module as described above in any of its embodiments, wherein the external decision taking module (µC) is configured to disconnect the current flow in at least one pre-determined humidity-prone zone Zj of at least one of the outer surfaces of the two outer layers of a printed circuit board (PCB) in order to limit the effect of hydrolysis on at least one pre-determined humidity-prone zone Zj of said printed circuit board (PCB) when the level of humidity exceeds a predetermined threshold.

In addition, since the humidity sensor makes use of components that are already present in a wide range of sub-assembly of various electronic control units embedded systems, such as the printed circuit board PCB, or are common for most industries: resistors, capacitors, switches, the humidity sensor has the economic advantage of being economically efficient.

The invention discloses in a third aspect a humidity sensor comprising the humidity sensing module as described above in any of its embodiments. The humidity sensor has all the advantages of the humidity sensing module. Alternatively, the humidity sensor may comprise said hydrolysis prevention module, having all the advantages mentioned above.

The external decision taking module µC may send the results of its interpretation to a display providing information regarding the level of humidity on the at least one pre-determined humidity-prone zone Zj of at least one of the outer surfaces of the two outer layers of a printed circuit board (PCB).

Alternatively, the external decision taking module µC may send specific instructions depending on the different voltage level between said resistors R1, R2 to at least one actuator which may take the appropriate actions to prevent damage caused by humidity of the printed circuit board PCB depending on the characteristics and the functions of the printed circuit board PCB and of the sub-assembly where said printed circuit board PCB is used.

## Claims

1. Humidity sensing module for detecting humidity on at least one pre-determined humidity-prone zone Zj of at least one of the outer surfaces of the two outer layers of a printed circuit board (PCB), said printed circuit board (PCB) being connected to a voltage source (Vcc), and comprising:
- at least two electrically conductive layers (L₁... Lₙ) :
• the first of the at least two electrically conductive layers being the ground plane (L₁) and
• the other of at least two electrically conductive layer being a signal layer (L₂...Lₙ) supporting electrical or electronical components
wherein said humidity sensing module further comprises:
- a transistor layer (L_{T}) as a further signal layer, said transistor layer (L_{T}) and said ground plane (L1) being connected to said voltage source (Vcc) by two resistors (R1, R2) configured to work as a voltage divider such us :
• said ground plane (L1) is connected to voltage source (Vcc) by a first resistor (R1) and a second resistor (R2), and
• said transistor layer (L_{T}) is connected to said voltage source (Vcc) between said first resistor (R1) and said second resistor (R2),
- a plurality of vias (Vi+, Vi-) arranged in pairs, such that:
• the positive via of each pair (Vi+) has an end connected to at least one pre-determined humidity-prone zone Zj of one of the outer surfaces of the two outer layers and the other end connected to said transistor layer (L_{T});
• the negative via of each pair (Vi-) has an end connected to at least one pre-determined humidity-prone zone Zj of the same outer surface of the two outer layers and the other end connected to said ground plane (L₁);
- an external decision taking module (µC) connected between said two resistors (R1, R2), being configured to read the signal and interpret it depending on the different voltage level between said resistors (R1, R2),
said humidity sensing module being configured such that when humidity between a positive via (Vi+) and a negative via (Vi-), placed at a predetermined distance (d) between them on the same outer surface, exceeds a humidity threshold, they become electrically connected determining a signal of different voltage level between said resistors (R1, R2) depending on the level of humidity and thus allowing said signal to be read and interpreted by said external decision taking module (µC).

2. Humidity sensing module as claimed in claim 1, wherein said transistor layer (L_{T}) is placed between the ground plane (L₁) and the other at least one layer (L₂...Lₙ) electrically conductive.

3. Humidity sensing module as claimed in claim 1, wherein said transistor layer (L_{T}) is placed as one of the two outer layers of the printed circuit board (PCB).

4. Humidity sensing module as claimed in any of the preceding claims, wherein the specific signal on the voltage between the two resistors is an analogical signal having a value which varies directly proportional with humidity level between the positive via (Vi+) and negative via (Vi-) placed at said predetermined distance (d).

5. Humidity sensing module as claimed in any of the claims 1 to 3, wherein said humidity sensing module further comprises a transistor (T) connected with its emitter to said voltage source (Vcc) by said first resistor (R1), with its collector directly to said ground plane (L₁) and its base directly to said transistor layer (L_{T}), and said second resistor (R2) being connected between emitter and the direct connection between base and Transistor layer (L_{T}) ;
said transistor (T) being configured to work as a switch from Open Switch to Close Switch and from Close Switch to Open Switch depending on the difference of voltage between said two resistors.

6. Humidity sensing module as claimed in claim 5, wherein the external decision taking module (µC) may be a micro-controller or a logical gate.

7. Humidity sensing module as claimed in claim 5 or 6, wherein it further comprises a resistor (R3) connected to the base of the transistor to provide stability of the signal, and at least a capacitor (C1) between the ground plane (L1) and the Transistor layer (L_{T}) to filter the signal.

8. Hydrolysis prevention module **characterized in that** it comprises the humidity sensing module as claimed in any of the preceding claims, wherein the external decision taking module (µC) is configured to disconnect the current flow in at least one pre-determined humidity-prone zone Zj of at least one of the outer surfaces of the two outer layers of said printed circuit board (PCB) in order to limit the effect of hydrolysis on said at least one pre-determined humidity-prone zone Zj when the level of humidity exceeds a predetermined threshold.

9. Humidity sensor **characterized in that** it comprises the humidity sensing module as claimed in any of the claims 1 to 7, or the hydrolysis prevention module as claimed in claim 8.

## Patentansprüche

1. Feuchtigkeitsmessmodul zum Erkennen von Feuchtigkeit auf mindestens einer vorbestimmten feuchtigkeitsgefährdeten Zone Zj von mindestens einer der Außenflächen der beiden äußeren Schichten einer Leiterplatte (PCB), wobei die Leiterplatte (PCB) mit einer Spannungsquelle (Vcc) verbunden ist, und Folgendes umfassend:
- mindestens zwei elektrisch leitende Schichten (L₁... Lₙ):
• wobei die erste der mindestens zwei elektrisch leitenden Schichten die Grundplatte (L₁) ist und
• die andere der mindestens zwei elektrisch leitenden Schichten eine Signalschicht (L₂...Lₙ) ist, die elektrische oder elektronische Komponenten trägt,
wobei das Feuchtigkeitsmessmodul ferner Folgendes umfasst:
- eine Transistorschicht (L_{T}) als eine weitere Signalschicht, wobei die Transistorschicht (L_{T}) und die Grundplatte (L1) mit der Spannungsquelle (Vcc) durch zwei Widerstände (R1, R2) verbunden sind, die dafür ausgebildet sind, als ein Spannungsteiler zu arbeiten, wie z. B.:
• die Grundplatte (L1) ist über einen ersten Widerstand (R1) und einen zweiten Widerstand (R2) mit der Spannungsquelle (Vcc) verbunden, und
• die Transistorschicht (L_{T}) ist zwischen dem ersten Widerstand (R1) und dem zweiten Widerstand (R2) mit der Spannungsquelle (Vcc) verbunden,
- eine Vielzahl von Durchkontaktierungen (Vi+, Vi-), die paarweise angeordnet sind, so dass:
• die positive Durchkontaktierung jedes Paares (Vi+) ein Ende hat, das mit mindestens einer vorbestimmten feuchtigkeitsgefährdeten Zone Zj einer der Außenflächen der beiden äußeren Schichten verbunden ist, und das andere Ende mit der Transistorschicht (L_{T}) verbunden ist;
• die negative Durchkontaktierung jedes Paares (Vi-) ein Ende hat, das mit mindestens einer vorbestimmten feuchtigkeitsgefährdeten Zone Zj der gleichen Außenfläche der beiden äußeren Schichten verbunden ist, und das andere Ende mit der Grundplatte (L₁) verbunden ist;
• ein externes Entscheidungsfindungsmodul (µC), das zwischen die beiden Widerstände (R1, R2) geschaltet ist und dafür ausgebildet ist, das Signal zu lesen und es in Abhängigkeit von dem unterschiedlichen Spannungspegel zwischen den Widerständen (R1, R2) zu interpretieren,
wobei das Feuchtigkeitsmessmodul so ausgebildet ist, dass, wenn die Feuchtigkeit zwischen einer positiven Durchkontaktierung (Vi+) und einer negativen Durchkontaktierung (Vi-), die in einem vorbestimmten Abstand (d) zwischen ihnen auf derselben Außenfläche angeordnet sind, einen Feuchtigkeitsschwellenwert überschreitet, sie elektrisch verbunden werden und ein Signal mit einem unterschiedlichen Spannungspegel zwischen den Widerständen (R1, R2) in Abhängigkeit von dem Feuchtigkeitspegel bestimmen und somit ermöglichen, dass das Signal durch das externe Entscheidungsfindungsmodul (µC) gelesen und interpretiert wird.

2. Feuchtigkeitsmessmodul nach Anspruch 1, wobei die Transistorschicht (L_{T}) zwischen der Grundplatte (L₁) und der anderen mindestens einen Schicht (L₂...Lₙ) elektrisch leitend angeordnet ist.

3. Feuchtigkeitsmessmodul nach Anspruch 1, wobei die Transistorschicht (L_{T}) als eine der beiden äußeren Schichten der Leiterplatte (PCB) angeordnet ist.

4. Feuchtigkeitsmessmodul nach einem der vorhergehenden Ansprüche, wobei das spezifische Signal an der Spannung zwischen den beiden Widerständen ein analoges Signal mit einem Wert ist, der direkt proportional zum Feuchtigkeitsniveau zwischen der positiven Durchkontaktierung (Vi+) und der negativen Durchkontaktierung (Vi-), die in dem vorgegebenen Abstand (d) angeordnet sind, variiert.

5. Feuchtigkeitsmessmodul nach einem der Ansprüche 1 bis 3, wobei das Feuchtigkeitsmessmodul ferner einen Transistor (T) umfasst, der mit seinem Emitter über den ersten Widerstand (R1) an die Spannungsquelle (Vcc), mit seinem Kollektor direkt an die Grundplatte (L₁) und mit seiner Basis direkt an die Transistorschicht (L_{T}) angeschlossen ist, und wobei der zweite Widerstand (R2) zwischen Emitter und der direkten Verbindung zwischen Basis und Transistorschicht (L_{T}) angeschlossen ist;
wobei der Transistor (T) dafür ausgebildet ist, in Abhängigkeit von der Spannungsdifferenz zwischen den beiden Widerständen als Schalter von Open Switch zu Close Switch und von Close Switch zu Open Switch zu arbeiten.

6. Feuchtigkeitsmessmodul nach Anspruch 5, wobei das externe Entscheidungsfindungsmodul (µC) ein Mikrocontroller oder ein Logikgatter sein kann.

7. Feuchtigkeitsmessmodul nach Anspruch 5 oder 6, wobei es ferner einen Widerstand (R3) umfasst, der mit der Basis des Transistors verbunden ist, um die Stabilität des Signals bereitzustellen, und mindestens einen Kondensator (C1) zwischen der Grundplatte (L1) und der Transistorschicht (L_{T}), um das Signal zu filtern.

8. Hydrolyseverhinderungsmodul, **dadurch gekennzeichnet, dass** es das Feuchtigkeitsmessmodul umfasst, wie es in einem der vorhergehenden Ansprüche beansprucht wird, wobei das externe Entscheidungsfindungsmodul (µC) ausgebildet ist, um den Stromfluss in mindestens einer vorbestimmten feuchtigkeitsgefährdeten Zone Zj von mindestens einer der Außenflächen der beiden äußeren Schichten der Leiterplatte (PCB) zu unterbrechen, um die Wirkung der Hydrolyse auf die mindestens eine vorbestimmte feuchtigkeitsgefährdete Zone Zj zu begrenzen, wenn der Feuchtigkeitspegel einen vorbestimmten Schwellenwert überschreitet.

9. Feuchtigkeitssensor, **dadurch gekennzeichnet, dass** er das Feuchtigkeitsmessmodul nach einem der Ansprüche 1 bis 7 oder das Hydrolyseverhinderungsmodul nach Anspruch 8 umfasst.

## Revendications

1. Module de détection d'humidité destiné à détecter l'humidité sur au moins une zone prédéterminée sujette à l'humidité Zj d'au moins une des surfaces extérieures des deux couches extérieures d'une carte de circuit imprimé (PCB), ladite carte de circuit imprimé (PCB) étant connectée à une source de tension (Vcc), et comprenant :
- au moins deux couches électriquement conductrices (L₁...Lₙ):
• la première des au moins deux couches électriquement conductrices étant le plan de masse (L₁) et
• l'autre des au moins deux couches électriquement conductrices étant une couche de signal (L₂...Lₙ) supportant des composants électriques ou électroniques où ledit module de détection d'humidité comprend en outre :
- une couche de transistor (L_{T}) en tant que couche de signal supplémentaire, ladite couche de transistor (L_{T}) et ledit plan de masse (L1) étant connectés à ladite source de tension (Vcc) par deux résistances (R1, R2) configurées pour fonctionner comme un diviseur de tension tel que :
• ledit plan de masse (L1) est relié à la source de tension (Vcc) par une première résistance (R1) et une seconde résistance (R2), et
• ladite couche de transistors (L_{T}) est connectée à ladite source de tension (Vcc) entre ladite première résistance (R1) et ladite seconde résistance (R2),
- une pluralité de trous d'interconnexion (Vi+, Vi-) disposés par paires, de telle sorte que :
• le trou d'interconnexion positif de chaque paire (Vi+) présente une extrémité connectée à au moins une zone prédéterminée sujette à l'humidité Zj de l'une des surfaces extérieures des deux couches externes et l'autre extrémité connectée à ladite couche de transistor (L_{T}) ;
• le trou d'interconnexion négatif de chaque paire (Vi-) présente une extrémité connectée à au moins une zone prédéterminée sujette à l'humidité Zj de la même surface extérieure des deux couches extérieures et l'autre extrémité connectée audit plan de masse (L₁) ;
- un module externe de prise de décision (µC) connecté entre lesdites deux résistances (R1, R2), étant configuré pour lire le signal et l'interpréter en fonction du niveau de tension différent entre lesdites résistances (R1, R2),
ledit module de détection d'humidité étant configuré de telle sorte que lorsque l'humidité entre un trou d'interconnexion positif (Vi+) et un trou d'interconnexion négatif (Vi-), placés à une distance prédéterminée (d) entre eux sur la même surface extérieure, dépasse un seuil d'humidité, ils deviennent électriquement connectés, déterminant un signal de niveau de tension différent entre lesdites résistances (R1, R2) en fonction du niveau d'humidité et permettant ainsi à ce signal d'être lu et interprété par ledit module externe de prise de décision (µC).

2. Module de détection d'humidité tel que revendiqué dans la revendication 1, dans lequel ladite couche de transistor (L_{T}) est placée entre le plan de masse (L₁) et l'au moins une autre couche (L₂...Lₙ) électriquement conductrice.

3. Module de détection d'humidité tel que revendiqué dans la revendication 1, dans lequel ladite couche de transistor (L_{T}) est placée comme l'une des deux couches extérieures de la carte de circuit imprimé (PCB).

4. Module de détection d'humidité tel que revendiqué dans l'une quelconque des revendications précédentes, dans lequel le signal spécifique sur la tension entre les deux résistances est un signal analogique ayant une valeur qui varie directement proportionnellement au niveau d'humidité entre le trou d'interconnexion positif (Vi+) et le trou d'interconnexion négatif (Vi-) placés à ladite distance prédéterminée (d).

5. Module de détection d'humidité tel que revendiqué dans l'une quelconque des revendications 1 à 3, dans lequel ledit module de détection d'humidité comprend en outre un transistor (T) connecté avec son émetteur à ladite source de tension (Vcc) par ladite première résistance (R1), avec son collecteur directement sur ledit plan de masse (L₁) et sa base directement sur ladite couche de transistor (L_{T}), et ladite deuxième résistance (R2) étant connectée entre l'émetteur et la connexion directe entre la base et la couche de transistor (L_{T}) ; ledit transistor (T) étant configuré pour fonctionner comme un commutateur de Commutateur ouvert à Commutateur fermé et de Commutateur fermé à Commutateur ouvert en fonction de la différence de tension entre lesdites deux résistances.

6. Module de détection d'humidité tel que revendiqué dans la revendication 5, dans lequel le module externe de prise de décision (µC) peut être un microcontrôleur ou une porte logique.

7. Module de détection d'humidité tel que revendiqué dans la revendication 5 ou la revendication 6, dans lequel il comprend en outre une résistance (R3) connectée à la base du transistor pour assurer la stabilité du signal, et au moins un condensateur (C1) entre le plan de masse (L1) et la couche de transistor (L_{T}) pour filtrer le signal.

8. Module de prévention de l'hydrolyse **caractérisé en ce qu'**il comprend le module de détection d'humidité tel que revendiqué dans l'une quelconque des revendications précédentes, dans lequel le module de prise de décision externe (µC) est configuré pour déconnecter le flux de courant dans au moins une zone prédéterminée sujette à l'humidité Zj d'au moins une des surfaces extérieures des deux couches extérieures dudit circuit imprimé (PCB) afin de limiter l'effet de l'hydrolyse sur ladite au moins une zone prédéterminée sujette à l'humidité Zj lorsque le niveau d'humidité dépasse un seuil prédéterminé.

9. Capteur d'humidité **caractérisé en ce qu'**il comprend le module de détection d'humidité tel que revendiqué dans l'une quelconque des revendications 1 à 7, ou le module de prévention de l'hydrolyse tel que revendiqué dans la revendication 8.
